# EUROPEAN PATENT APPLICATION

(11) **EP 4 692 933 A2**
(43) Date of publication of application: **11.02.2026**
(21) Application number: 25201118.4
(22) Date of filing: 09.09.2025
(51) Int. Cl.: G03F 7/00, G03F 9/00

(54) **SUBSTRATE SUPPORT COMPARTMENT, EXPOSURE APPARATUS, AND COMPUTER-IMPLEMENTED METHOD OF SCANNING A SUBSTRATE**

(71) Applicant: ASML Netherlands B.V., 5500 AH Veldhoven (NL)
(72) Inventor: VAN DEN BELD, David Hendrik Theodoor, 5500 AH Veldhoven (NL); MORAIS CAVALCANTE, Denis, 5500 AH Veldhoven (NL); ROTURIER, Nils Johan Pierre, 5500 AH Veldhoven (NL); KULESH, Ivan Pavlovich, 5500 AH Veldhoven (NL); TRIANTAFYLLOU, Nikolaos, 5500 AH Veldhoven (NL); SEN, Arda, 5500 AH Veldhoven (NL); SWINKELS, Daan, 5500 AH Veldhoven (NL); ESQUIVEL PINTO, Claudia Sofia, 5500 AH Veldhoven (NL); TREVISAN KOTHE, Xano, 5500 AH Veldhoven (NL); HELDER, Matthieu Wouter Jan, 5500 AH Veldhoven (NL)
(74) Representative: ASML Netherlands B.V.

(57) **Abstract**

A substrate support compartment for an exposure apparatus comprising a substrate support assembly, a level sensor, an alignment sensor, and a control unit. The substrate support assembly comprises a movable substrate support configured to support a substrate. The control unit is configured to control the movable substrate support to displace the substrate relative to the level sensor according to a predefined path in order for the level sensor to determine a substrate height map. The control unit is further configured to control the movable substrate support to adjust the displacement of the substrate at an adjustment point along the predefined path in order for the alignment sensor to determine a position of an alignment mark which is arranged at or near the adjustment point along the predefined path.

## Description

### FIELD

The present invention relates to the field of lithography and semiconductor manufacturing. The present invention in particular pertains to a substrate support compartment for an exposure apparatus, an exposure apparatus comprising such a substrate support compartment, a computer-implemented method of scanning a substrate, and a computer program comprising instructions for executing the computer-implemented method.

### BACKGROUND

An exposure apparatus is for example a lithographic apparatus. A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A lithographic apparatus generally comprises a substrate support assembly - e.g., an object stage or a wafer stage - which comprises a movable substrate support (e.g., an object table). The movable substrate support is configured to support a substrate (e.g., an object or wafer). The substrate support assembly is comprised in a substrate support compartment, which further comprises several sensors. Prior to exposure of the substrate, various measurements are performed on the substrate by these sensors. An alignment process is performed in which a position of one or more alignment marks arranged on the substrate are determined. The alignment process may for example comprise two sequential sub-processes: a coarse wafer alignment (COWA) and a fine wafer alignment (FIWA). The position of the one or more marks are for example determined by an alignment sensor. Further, a height map (or Z-map) of the substrate is determined by scanning across the substrate with a level sensor. This process is also referred to as wafer Z-map (WZM).

During the alignment process, the movable substrate support moves such that the substrate supported by the movable substrate support is displaced relative to the alignment sensor. Said displacement allows the alignment sensor to measure the position of the one or more marks on the substrate. During the WZM process, the movable substrate support moves such that the substrate supported on the movable substrate support is displaced relative to the level sensor. Said displacement allows the level sensor to scan across the substrate (e.g., according to a predefined pattern corresponding to the movement of the movable substrate support) to determine the height map of the substrate.

The various measurements which are performed on the substrate result in a total measurement time, e.g., to determine the position of one or more alignment marks and/or to determine the height map of the substrate. By minimizing the total measurement time, total throughput of the system may be increased and/or the accuracy of the measurements may be increased.

There is therefore a need for control algorithms for scanning a substrate supported on a movable substrate support. These control algorithms may have an impact on the total measurement time needed to perform various measurements on the substrate. It is an object of the invention to provide for such a control algorithm.

### SUMMARY

The object of the invention is achieved, according to a first aspect of the invention, by providing a substrate support compartment for an exposure apparatus. The substrate support compartment comprises a substrate support assembly configured to support a substrate, the substrate support assembly comprising a movable substrate support configured to support the substrate. The substrate support compartment further comprises a level sensor, an alignment sensor, and a control unit. The control unit is configured to: control the movable substrate support to displace the substrate relative to the level sensor according to a predefined path in order for the level sensor to determine a substrate height map; and to control the movable substrate support to adjust the displacement of the substrate at an adjustment point along the predefined path in order for the alignment sensor to determine a position of an alignment mark which is arranged at or near the adjustment point along the predefined path.

In an embodiment, the control unit is configured to control, while the substrate is displaced relative to the level sensor, the level sensor to determine the substrate height map; and control, while the displacement of the substrate is adjusted, the alignment sensor to determine the position of the alignment mark.

In an embodiment, the control unit is configured to control the level sensor to interrupt the determining of the substrate height map while the displacement of the substrate is adjusted.

In an embodiment, the predefined path comprises alternating scanning sections and return sections, and wherein the control unit is configured to control the movable substrate support to accelerate when the movable substrate support approaches a scanning section and to control the movable substrate support to decelerate when the substrate support approaches or enters a return section.

Optionally, the adjustment point along the predefined path is located along a scanning section of the predefined path.

In an embodiment, the control unit is configured to control the movable substrate support to decelerate when the movable substrate support approaches the adjustment point along the predefined path.

In an embodiment, the alignment sensor is configured to determine the position of the alignment mark by providing and scanning a patterned radiation beam relative to the alignment mark on the substrate.

In an embodiment, the control unit is configured to control the movable substrate support to move to a detecting area in which the alignment mark is detectable by the alignment sensor in order for the alignment sensor to determine the position of the alignment mark.

Optionally, the control unit is configured to control the movable substrate support to displace the substrate such that the alignment mark is displaced relative to the alignment sensor within the detecting area.

In an embodiment, the control unit is configured to, after the alignment sensor has determined the position of the alignment mark, control the movable substrate support to resume the displacement of the substrate relative to the level sensor from the adjustment point along the predefined path onwards.

Optionally, the control unit is configured to, after the alignment sensor has determined the position of the alignment mark and before controlling the movable substrate support to resume the displacement of the substrate relative to the level sensor from the adjustment point along the predefined path onwards, control the movable substrate support to move to a height measuring position in which the substrate height at the adjustment point along the predefined path is measurable by the level sensor.

In an embodiment, the control unit is configured to control the movable substrate support to accelerate from the adjustment point along the predefined path onwards.

In an embodiment, the alignment mark is arranged at a distance from the adjustment point along the predefined path, which distance is smaller than a threshold distance.

In an embodiment, the alignment mark is arranged near an edge of the substrate, e.g., at a distance of 0.5cm or 1cm from the edge of the substrate.

In an embodiment, the alignment sensor is configured to determine the position of the alignment mark in a support plane in which the substrate is configured to be supported on the substrate support, and wherein the level sensor is configured to measure the height of the substrate in a direction perpendicular to the support plane.

In an embodiment, the control unit is configured to control the movable substrate support to adjust the displacement of the substrate at a plurality of adjustment points along the predefined path in order for the alignment sensor to determine the positions of a plurality of alignment marks which are each arranged at or near a respective adjustment point along the predefined path.

Optionally, the positions of the plurality of alignment marks are determined as part of a course wafer alignment, COWA, procedure to determine location and orientation information of the substrate.

Optionally, the positions of the plurality of alignment marks determined as part of the COWA procedure are used as input to a fine wafer alignment, FIWA procedure.

The object of the invention is achieved, according to a second aspect of the invention, by providing an exposure apparatus comprising a substrate support compartment according to the first aspect of the invention.

The object of the invention is achieved, according to a third aspect of the invention, by providing a computer-implemented method of scanning a substrate supported by a movable substrate support of a substrate support compartment, the substrate support compartment further comprising an alignment sensor and a level sensor. The method comprises the step of controlling the movable substrate support to displace the substrate relative to the level sensor according to a predefined path in order for the level sensor to determine a substrate height map. The method further comprises the step of controlling the movable substrate support to adjust the displacement of the substrate at an adjustment point along the predefined path in order for the alignment sensor to determine a position of an alignment mark which is arranged at or near the adjustment point along the predefined path.

The object of the invention is achieved, according to a fourth aspect of the invention, by providing a computer program comprising instructions to cause the control unit of the substrate support compartment according to the first aspect of the invention to execute the steps of the method according to the third aspect of the invention.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figures 2a and 2b depict an object stage of a lithographic apparatus including one or more movable object tables, an alignment sensor, and a level sensor;
- Figure 3 depicts a first scanning pattern across an object;
- Figure 4 depicts a second scanning pattern across an object according to one or more embodiments of the invention;
- Figure 5 depicts a third scanning pattern across an object according to one or more embodiments of the invention;
- Figure 6 depicts a fourth scanning pattern across an object according to one or more embodiments of the invention;
- Figure 7 depicts a flow diagram of a method of scanning an object according to the invention.

### DETAILED DESCRIPTION

The invention will be explained in more detail below with reference to drawings in which illustrative embodiments thereof are shown. The drawings are intended exclusively for illustrative purposes and not as a restriction of the inventive concept which is to cover all modifications, equivalents, and alternatives falling within the scope of the present invention. The scope of the invention is only limited by the definitions presented in the appended claims.

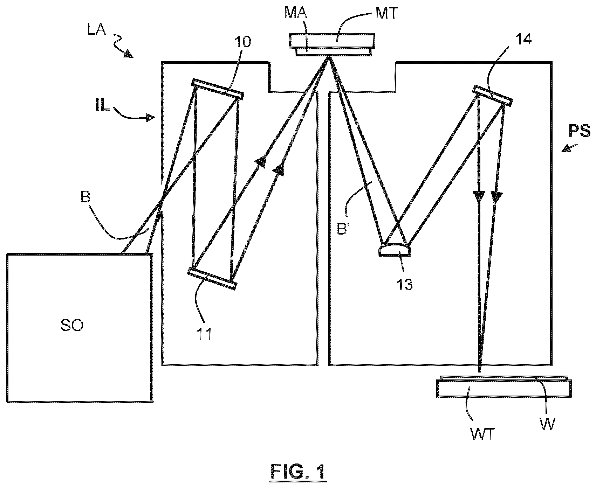

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W. The substrate table WT may also be referred to as a moveable substrate support.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

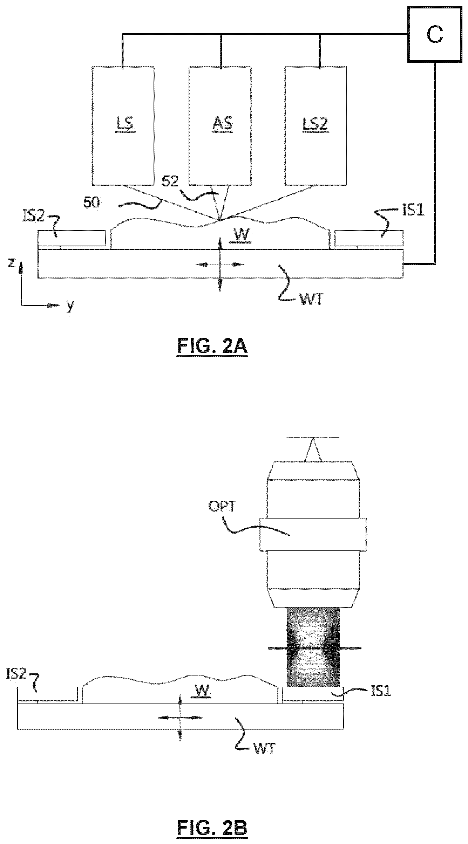

Referring to Figures 2A and 2B, the lithographic apparatus may include an object stage including one or more movable object tables WT. The object table WT is typically movable with respect to a base (not shown). In operation, the object table WT may be provided with a substrate W. Then, the object table WT first moves towards a measurement location or measurement side, exemplified in Figure 2A. Thereafter, the object tables moves to the expose side, see Figure 2B.

Although Figures 2A and 2B are shown as separate figures, please note that the measurement side (Fig. 2A) and the expose aside (Fig. 2B) may typically be located on opposite sides of the same base, with one or more substrate tables being able to move from side to side. The combination of expose side and measurement side may be referred to as the wafer stage or object stage.

For technical details of an object stage comprising multiple object tables, and the functionality thereof including measurement and exposure, reference is made to, for instance, patent US-6597433.

The object table is typically provided with one or more first sensors. The first sensors are image align sensors, such as a first image align sensor IS1 and a second image align sensor IS2. The first sensors are typically arranged relatively near to, or adjacent to, the intended position of the substrate W.

The measurement side of the object stage, see Fig. 2A, is typically provided with a number of other sensors. The measurement side may be provided with one or more of a second sensor and a third sensor. The second sensor may comprise an alignment sensor AS. The third sensor may comprise a level sensor LS. The level sensor LS, which also comprises a second part or detector part LS2, is adapted to measure height or topography of the object W on the object table. The alignment sensor AS may measure the alignment, for instance one or more of the horizontal position in one or both of the x-direction and y-direction, and rotation about the z-axis (Rz). The level sensor may measure height z and one or more of rotations Rx and Ry of the object W with respect to a predetermined setpoint position.

The alignment sensor AS may include a light source. The light source may be a source of second radiation 52, for instance visible light. The visible light herein may have a wavelength in the spectrum of about 380 to about 750 nanometers. Alternatively or in addition, the second sensor may use second radiation in the ultraviolet spectrum or the infrared spectrum. In use, an alignment mark on the object W is irradiated, for instance using the visible light. The reflected light is captured to assess a position of the mark.

The level sensor comprises a first part LS and a second part LS2. The first part may comprise a source of third radiation 50. The third radiation may be any suitable radiation for scanning the top surface of the substrate W. In use, the first level sensor part LS directs the third radiation 50 at the top surface of the substrate W. Herein, the top surface is the surface of the substrate W facing the level sensor and the alignment sensor, and facing away from the object table WT. The level sensor may be adapted to scan the third radiation across the surface of the substrate, in a predetermined pattern. The second level sensor part LS2 may detect the third radiation as it is reflected from the top surface, and use the detected reflection to determine the topology or height map of the top surface of the substrate W.

The measurement side of the object stage may also be referred to as a substrate support compartment.

A control unit C is in (direct or indirect) communication with the alignment sensor AS, the level sensor LS, and/or the object table WT. The control unit C is for example configured to transmit control signals over an electrical connection. The control unit C is configured to control the alignment sensor AS, the level sensor LS, and/or the object table WT to scan the object W in order to, e.g., determine the alignment of the object W and/or determine a height map of the object W. The alignment of the object W may be based on the measured position of one or more marks on the object W. The height map may represent the height z across the object W. The position of the one or more marks may be a horizontal position on the substrate support (along an X-Y axis). The height z across the object W may be the height in a vertical direction (along a Z-axis) which is perpendicular to the horizontal direction defined by the X-Y axis.

To scan the object, the control unit C controls the object table WT to move such that the object W is displaced relative to the alignment sensor AS and/or the level sensor LS.

According to one example, to determine the height map of the object W, the control unit C controls the object table WT to displace the object W relative to the level sensor LS according to a predefined path. While the object W is displaced, the control unit C controls the level sensor LS to scan the third radiation across the surface of the object W in a predetermined pattern. The predetermined pattern for scanning the object W corresponds to the predefined path along which the object W is displaced.

According to another example, to determine the alignment of object W, the control unit C controls the object table WT to displace the object W relative to the alignment sensor AS to a detecting area. The alignment mark is for example a pattern provided on the object W, and the pattern is detectable in the detecting area by the alignment sensor AS. The position of the alignment mark may be determined by the alignment sensor AS providing and scanning a patterned radiation beam relative to the alignment mark on the object W. For example, the object W is displaced within the detecting area (i.e., along the X-Y axis) while the patterned radiation beam is provided and scanned by the alignment sensor AS.

A typical alignment process comprises two sub-processes: coarse wafer align (COWA) and fine wafer align (FIWA).

During COWA, the position of one or more bidirectional COWA marks and/or COWA mark pairs (each mark pair comprising two marks) are measured by the alignment sensor AS. The COWA marks may have a high capture range. The COWA marks are for example arranged at the center of the object W along one direction (i.e., along one of the X axis and Y axis). The COWA marks are for example separated along the other direction (i.e., along the other of the X axis and Y axis) by a distance. The distance is for example within the range of 30%-70% of the object diameter, for example around 30% or 40% or 50% or 60% or 70% of the object diameter. In other examples, the COWA marks are separated along both directions (i.e., along both of the X axis and Y axis) by a distance within said range. The measurement data obtained by the alignment sensor AS related to the COWA marks typically comprises one or more of translation along the X axis and translation along the Y axis, object rotation about the z-axis (Rz), and object expansion. The measurement data is fed into a COWA model to determine information on the location and orientation of the object W with respect to a predetermined setpoint position and orientation.

During FIWA, the position of a plurality of FIWA marks are measured. The FIWA marks have a smaller capture range than the COWA marks. The amount of FIWA marks is typically larger than the amount of COWA marks. The result of COWA modelling, i.e., the information on the location and orientation of the object W, is used to measure the location of the FIWA marks. The COWA results may contribute to a more precise movement of the object table WT to displace the object W relative to the alignment sensor AS to (and within) a detecting area in which the FIWA marks are detectable. The measurement data obtained during FIWA is used, e.g., to determine wafer shape. To this end, the measurement data may be fed into a FIWA model.

During the various measurements (i.e., of the alignment marks and of the height map) which are performed on the substrate, the displacement of the movable substrate support results in travel time of the movable substrate support. The total travel time needed for the various measurements may have an impact on the total throughput of the system (i.e., less travel time is associated with a higher throughput) and/or the accuracy of the measurements (e.g., additional marks can be determined using the same travel time in COWA and/or FIWA).

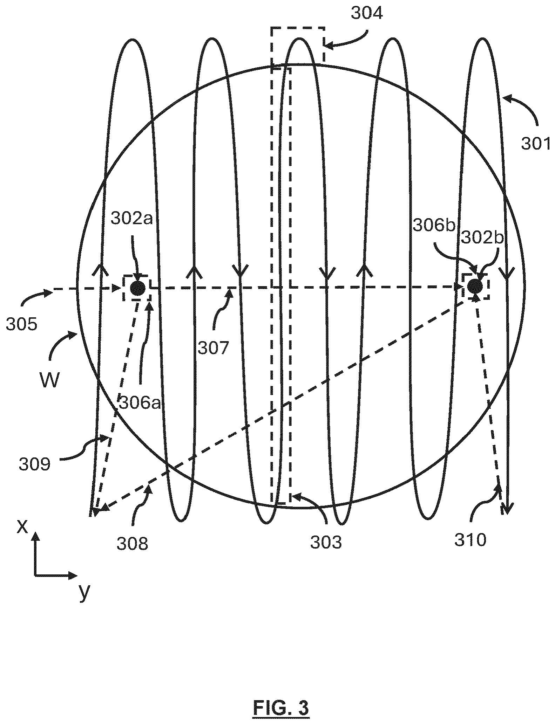

Fig. 3 schematically shows a predetermined scanning pattern 301 across object W for scanning the object W to determine a height map of the object W. Fig. 3 also shows two COWA marks 302a and 302b arranged on the object W.

Typically, the level sensor LS remains stationary during scanning of the substrate C to determine the height map of the object W. The control unit C is therefore configured to control the object table WT (i.e., the movable substrate support) to displace the object W (i.e., the substrate) according to a predefined path which corresponds to predetermined scanning pattern 301. In other words, the object W is displaced according to the predefined path such that the level sensor LS may scan the object W according to the predetermined scanning pattern 301. The predefined path comprises alternating scanning sections and return sections - an example scanning section 303 and an example return section 304 are shown in Fig. 3. While the object W is displaced (e.g., at a constant velocity) along a scanning section 303, the control unit C is configured to control the level sensor to scan the object W to determine the height map of the object W.

The predefined path as shown in Fig. 3 is depicted as a meandering path. Alternatively, the predefined path may exclusively comprise of movements in two perpendicular directions, i.e., in one direction along the X-axis (where the Y-component of the velocity is 0) and one direction along the Y-axis (where the X-component of the velocity is 0).

When the object table WT approaches a scanning section 303, such as for example at the start of the predefined path, the control unit C is configured to control the object table WT to accelerate (e.g., up to the constant velocity at which the object W is to be displaced along a scanning section 303). Alternatively, the control unit C is configured to control the object table WT to accelerate when the object table WT enters a scanning section 303. In other words, the control unit C is configured to control the object table WT to accelerate when the object table WT is at or near an edge of the object W.

When the object table WT approaches or enters a return section 304, the control unit C is configured to instruct the object table WT to decelerate. For example, the control unit C is configured to instruct the object table WT to decelerate when the object table WT approaches an edge of the object 301. In a return section 304, the controller C is configured to control the object table WT to displace the object W in a (horizontal) direction (e.g., along the y-axis) which is arranged at an angle, e.g., perpendicular to the direction of displacement of the object W along a scanning section 303 (e.g., along the x-axis). This displacement causes the object W to be aligned with the next scanning section. Then, the controller C is configured to control the object table WT to displace the object W in a direction which is the inverse of the direction of displacement along the scanning section 303 and to accelerate before entering the next scanning section. The direction of displacement of the object W with respect to the level sensor LS is shown with arrows along the scanning sections in Fig. 3.

To measure the position of the COWA marks (i.e., alignment marks) 302a and 302b, the controller C is configured to instruct the object table WT to displace the object W to a detecting area in which the COWA mark is detectable by the alignment sensor AS. For example, the controller C instructs the object table WT to displace the object W to detecting area 306a for detecting COWA mark 302a along path 305. Once the alignment sensor AS has determined the position of COWA mark 302a, the controller C may instruct the object table WT to displace the object W to detecting area 306b for detecting COWA mark 302b along path 307. The alignment sensor AS is configured to determine the position of the COWA marks 302a, 302b by providing and scanning a patterned radiation beam relative to the COWA marks 302a, 302b on the object W. To scan the radiation beam relative to the COWA marks 302a, 302b, the controller C is configured to instruct the object table WT to displace the object W relative to the alignment sensor AS. To this end, for example, the object W is displaced relative to the alignment sensor AS within the detecting area 306a to determine the position of COWA mark 302a and within the detecting area 306b to determine the position of COWA mark 302b.

Once the alignment sensor AS has determined the position of COWA mark 302b, the controller C may instruct the object table WT to displace the object W to a starting point of predetermined scanning pattern 301 along path 308. The process of determining the height map may then start by the controller C controlling the object table WT to displace the object W along the predefined path corresponding to predetermined scanning pattern 301. In this way, the process of determining the position of the COWA marks and the process of determining the height map of the object W are performed sequentially. The order in which the position of the COWA marks 302a, 302b are determined may be reversed. The order in which the COWA process and the height map process are performed may be reversed.

Alternatively, the COWA process and the height map process may be (partly) interleaved by performing the WZM process in between the measurement of the two COWA marks. For example, the controller C instructs the object table WT to displace the object W to detecting area 306a for detecting COWA mark 302a along path 305. Once the alignment sensor AS has determined the position of COWA mark 302a, the controller C may instruct the object table WT to displace the object W to a starting point of predetermined scanning pattern 301 along path 309. The process of determining the height map may then start by the controller C controlling the object table WT to displace the object W along the predefined path corresponding to predetermined scanning pattern 301. Once the level sensor LS has determined the height map, the controller C may instruct the object table WT to displace the object W to detecting area 306b for detecting COWA mark 302b along path 310.

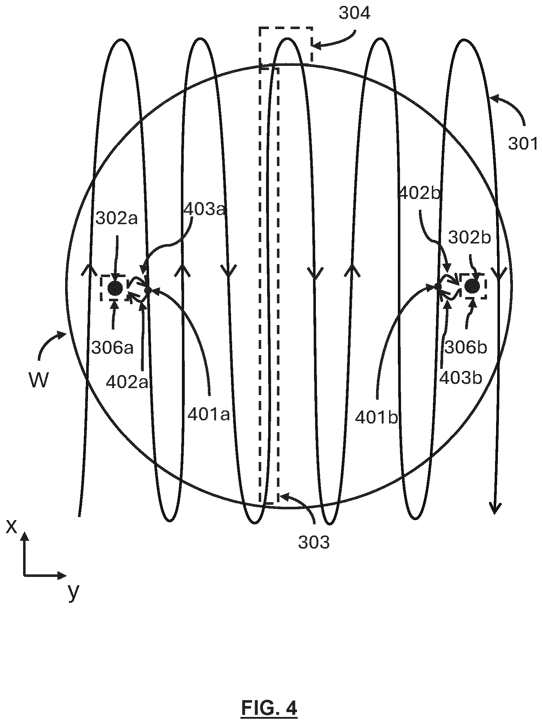

According to the invention, the COWA process and the height map process (i.e., wafer Z-map (WZM)) may be combined. An example of a combined COWA-WZM is shown in Fig. 4. In the combined COWA-WZM process, the measurement of the COWA marks is performed during the WZM process.

In the example shown in Fig. 4, the control unit C is configured to control the object table WT to displace the object W relative to the level sensor LS according to a predefined path corresponding to predetermined scan pattern 301 in order for the level sensor LS to determine a substrate height map. The control unit C is further configured to control the object table WT to adjust the displacement of the object W at an adjustment point 401a, 401b along the predefined path in order for the alignment sensor AS to determine a position of a COWA mark 302a, 302b which is arranged near the adjustment point 401a, 401b along the predefined path. For example, the alignment mark is arranged at a distance from the adjustment point 401a, 401b along the predefined path, which distance is smaller than a threshold distance. The threshold distance is for example in the range of 10µm - 1mm. For example, the threshold distance is smaller than 1mm, for example 100µm.

To adjust the displacement of the object W at the adjustment point (e.g., adjustment point 401a or 401b), the controller is configured to control the object table WT to move (from the adjust point) to a detecting area (e.g., detecting area 306a or 306b) in which the alignment mark (e.g., COWA mark 302a or 302b) is detectable by the alignment sensor AS. The controller is for example configured to control the object table WT to move from the interruption point 401a along a first stroke 402a to detecting area 306a. Once the object table WT has reached or is within the detection area 306a, the control unit C is configured to instruct the alignment sensor AS to determine the position of alignment mark 302a.

The control unit C is configured to control, after the position of alignment mark 302a is determined, the object table WT to resume the displacement of the object W relative to the level sensor LS from the adjustment point 401a along the predefined path onwards. The control unit C is configured to, after the alignment sensor AS has determined the position of the COWA mark 302a and before controlling the object table WT to resume the displacement of the object W relative to the level sensor LS from the adjustment point along the predefined path onwards, control the object table WT to move to a height measuring position in which the substrate height at the adjustment point 401a along the predefined path is measurable by the level sensor LS. The controller is for example configured to control the object table WT to move from the detecting area 306a to the interruption point 401a along a second stroke 402a. The WZM process may then be resumed from the interruption point 401a onwards. To resume the WZM process from the interruption point 401a onwards, the control unit C is configured to instruct the level sensor LS to determine the height map of the object W from the interruption point 401a onwards. Before the WZM process was interrupted, the level sensor LS has determined a partial height map of the object W, i.e., a height map of the object W up to the (and optionally including) a measurement at the interruption point 401a. After resuming the WZM process, the partial height map is the starting point for the WZM process. The level sensor LS continues to perform measurements starting from (and optionally including) a measurement at the interruption point 401a. In this way, a continuous height map is obtained according to predetermined scanning pattern 301. The obtaining of the continuous height map may require combining, i.e., stitching, multiple partial height maps. Each of the multiple height height maps are obtained along part of the predefined path, i.e., the part of the predefined path before and/or after reaching an adjustment point.

The displacement of the object W may similarly be adjusted at adjustment point 401b over first stroke 402b towards detection area 306b to determine the position of COWA mark 302b. Similarly, the controller may be configured to control the object table WT to move from the detecting area 306b to the interruption point 401b along a second stroke 402b. The WZM process may then be resumed from the interruption point 401b onwards.

The first and second strokes 402a-b and 403a-b are for example a shortest path from the interruption points 403a-b to the detection area 306a-b and/or the COWA marks 302a-b. The first and second strokes 402a-b may be arranged perpendicular to the direction in which the object table WT is displaced along the predefined path.

The control unit C is configured to control the level sensor LS, while the object W is displaced relative to the level sensor LS, to determine the substrate height map. The control unit C is further configured to control, while the displacement of the object W is adjusted, the alignment sensor AS to determine the position of the COWA mark 302a, 302b.

The velocity at which the object W is to be displaced with respect to the alignment sensor AS to measure the position of the COWA marks 302a, 302b is typically lower than the velocity at which the object W is to be displaced with respect to the level sensor LS to determine the substrate height map. Therefore, the control unit C may be configured to control the object table WT to displace the object W at a velocity within the detection area 306a-b which is lower than the velocity with which the object W is displaced along the predefined path.

The control unit C may be configured to control the level sensor LS to interrupt the determining of the substrate height map while the displacement of the object W is adjusted. The control unit C may then also be configured to control the level sensor LS to resume the determining of the substrate height map once the position of the COWA mark has been determined and the displacement of the substrate W relative to the level sensor LS is resumed from the adjustment point 401a along the predefined path onwards.

The control unit C may be configured to control the object table WT to decelerate when the object table WT approaches the adjustment point 401a-b along the predefined path. As a result, the object W is displaced at a decreasing velocity along the predefined path 301 until the adjustment point 401a-b is reached. In some examples, the velocity of the object table WT is reduced to near-zero or 0 (i.e., standstill) when the object table WT reaches the adjustment point 401a-b. The control unit C may similarly be configured to control the object table WT to accelerate from the adjustment point 401a-b along the predefined path onwards, for example after the position of the alignment mark 302a-b has been determined and the WZM process is resumed.

The combined COWA-WZM process as explained with reference to Fig. 4 (and, similarly, also with reference to the below figures) may contribute to a faster total measurement time of COWA and WZM. The time gain, when compared to a sequential performing of COWA and WZM or a partial interleaving of COWA and WZM, as for example shown in Fig. 3, may be in the order of several hundreds of milliseconds, for example in the range of 100-600ms. This time gain may contribute to a higher throughput of the exposure apparatus. Alternatively or additionally, this time gain may contribute to an improved On Product Overlay (OPO) as the position of additional FIWA marks can be determined in the same amount of time. The OPO improvement may for example be in the range of 0.01-0.02nm.

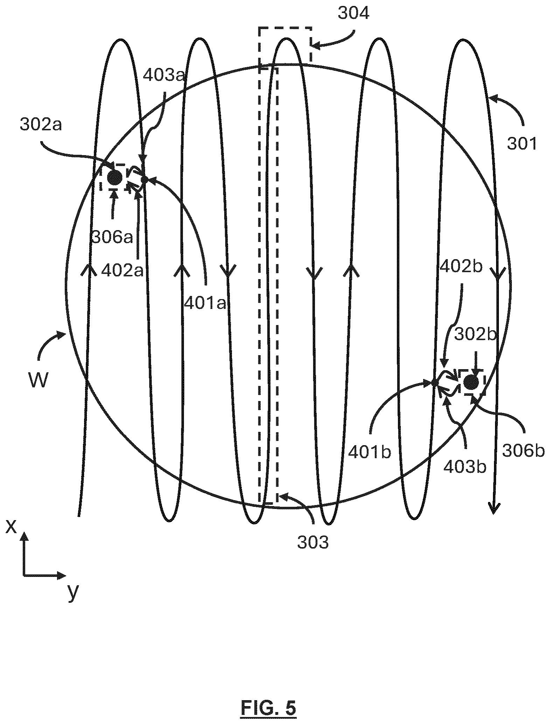

Fig. 5 depicts an object W on which two COWA marks 302a, 302b are arranged near an edge of the object W, e.g., at a distance of 0.5cm or 1cm from the edge of the object W.

The control unit C is in general configured to control the object table WT to displace the object W similarly to the example shown in Fig. 4.

The control unit C is configured to control the object table WT to adjust the displacement of the object W at adjustment points 401a-401b in order for the alignment sensor AS to determine the position of alignment marks 302a-302b which are arranged near the edge of the object W, e.g., at a distance of 0.5cm or 1cm from the edge of the object W.

In such a case, the object W is for example accelerated from the edge of the object W onwards along the predefined path up to a velocity which is lower than the maximum velocity that the of the object table WT. Thus, the deceleration time of the object table WT when approaching the adjustment point 401a is shorter than a case where the object W may be displaced along the predefined path at its maximum velocity. Additionally, after the object table WT has accelerated from the adjustment point onwards after the position of the alignment mark has been determined, the object table WT may travel for a longer time at maximum velocity. Therefore, the total measurement time of the combined COWA-WZM process may further be reduced.

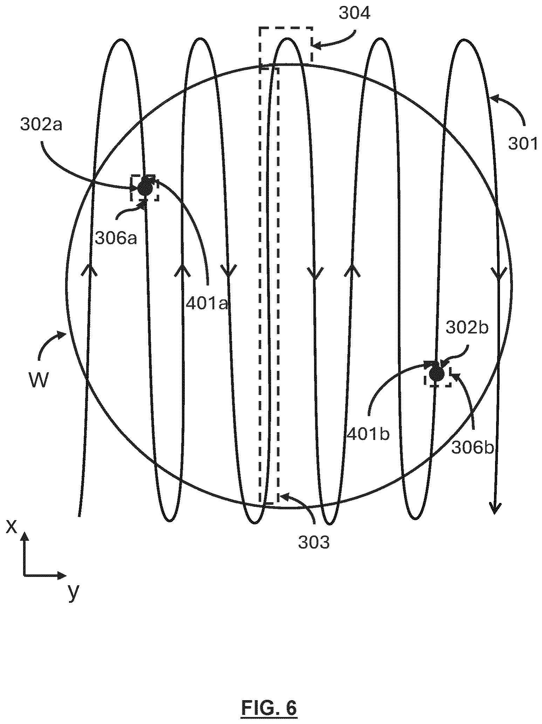

Fig. 6 depicts an object W on which two COWA marks 302a-b are arranged along the predefined path. The position of the adjustment points 401a-b may therefore correspond to the position of the COWA marks 302a-b. Alternatively, the adjustment points 401a-b may be located within or at an edge of the detection areas 306a-b. In the example depicted in Fig. 6, adjustment point 401a is arranged within detection area 306a in front of alignment mark 302a, as seen in a travel direction of the WZM stroke along the predefined path 301. Adjustment point 401b is arranged within detection area 306b behind alignment mark 302b, as seen in a travel direction of the WZM stroke along the predefined path.

The control unit C is in general configured to control the object table WT similarly to the example shown in Fig. 4.

The control unit C is configured to control the object table WT to adjust the displacement of the substrate at adjustment points 401a-401b in order for the alignment sensor AS to determine the position of COWA marks 302a-302b which are arranged along the predefined path.

In such a case, the controller is configured to adjust the displacement of the object W by instructing the object table WT to displace the object relative to the alignment sensor AS. The alignment sensor AS is configured to determine the position of the COWA marks 302a-302b by providing and scanning a patterned radiation beam relative to the alignment mark on the substrate. The step of controlling the object table WT to move to the detecting area 306a-b may be skipped by the controller, as the detecting area 306a-b is reached by the object table WT as part of the displacement of the object W by the object table WT along the predefined path.

When approaching the adjustment point 401a-b, control unit C is configured to instruct the object table WT to decelerate. For example, control unit C is configured to instruct the object table WT to decelerate to a velocity that is appropriate for the alignment sensor AS to determine the position of the COWA marks 302a-302b. In other examples, the control unit C is configured to instruct the object table WT to stop at the adjustment points 302a-b, after which the control unit C is configured to instruct the object table WT to accelerate to a velocity that is appropriate for the alignment sensor AS to determine the position of the COWA marks 302a-302b.

The control unit C may be configured to, after the alignment sensor AS has determined the position of the COWA mark 302a-302b, control the object table WT to resume the displacement of the object W relative to the level sensor LS from the adjustment point 401a-b along the predefined path onwards.

To measure COWA mark 302a, the control unit C is configured to control the object table WT to decelerate while the object W is displaced along the predefined path until object W reaches adjustment point 401a. In this case, the object W has not yet passed a position in which alignment mark 302a is detectable by the alignment sensor AS before the obect W reaches adjustment point 401a. The control unit C is further configured to control the object table WT to displace the object relative to the alignment sensor AS in order for alignment sensor AS to determine the position of alignment mark 302a. After the position of alignment mark 302a has been determined, the control unit C is configured to control the object table WT to move back to the adjustment point 401a. Said moving back may involve displacement of the object W in a direction opposite to the direction of the predefined path. After object table WT has reached adjustment point 401a, the WZM process is resumed, which includes that the displacement of the object W along the predefined path is resumed.

To measure COWA mark 302b, the control unit C is configured to control the object table WT to decelerate while the object W is displaced along the predefined path until object W reaches adjustment point 401b. In this case, object W has already passed a position in which alignment mark 302a is detectable by the alignment sensor AS before object W reaches adjustment point 401b. The control unit C is further configured to control the object table WT to displace the object relative to the alignment sensor AS in order for alignment sensor AS to determine the position of alignment mark 302a. Said displacement may involve displacement of the object W in a direction opposite to the direction of the predefined path. After the position of alignment mark 302a has been determined, the control unit C is configured to control the object table WT to move back to the adjustment point 401a. Said moving back may involve displacement of the object W in a direction of the predefined path. Therefore, the displacement of the object W along the predefined path is resumed. While moving back, the control unit C may be configured to control the object table WT to accelerate along the predefined path. After object table WT has reached adjustment point 401a, the WZM process is resumed.

Although Figs. 3-6 all show two COWA marks 306a-b arranged on the object W, additional (pairs of) COWA marks 306a-b may be arranged on the object W along or near the predefined path. The control unit C is then configured to control the object table WT to adjust the displacement of the object W at adjustment points along the predefined path in order for the alignment sensor to determine the position of each of the COWA marks.

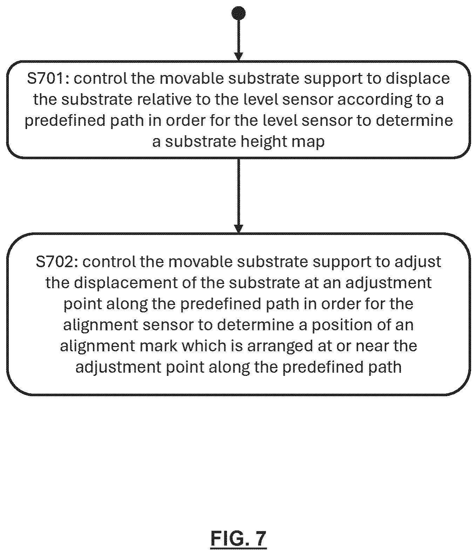

Fig. 7 depicts a flow diagram of a (computer-implemented) method of scanning an object W according to the invention, the object W being supported by a movable substrate support of a substrate support compartment, the substrate support compartment further comprising an alignment sensor and a level sensor.

The method comprises the step of controlling the movable substrate support (i.e., object table WT) to displace the substrate (i.e., object W) relative to the level sensor LS according to a predefined path in order for the level sensor LS to determine a substrate height map.

The method further comprises the step of controlling the movable substrate support to adjust the displacement of the substrate at an adjustment point along the predefined path in order for the alignment sensor to determine a position of an alignment mark which is arranged at or near the adjustment point along the predefined path.

The method may further comprise additional steps performed by controller C as disclosed with reference to the embodiments above. The invention further relates to a computer program comprising instructions to cause the control unit C to execute the steps of the computer-implemented method.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, control units, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Further, this document describes the following clauses of the present invention:
1. A substrate support compartment for an exposure apparatus comprising:
   a substrate support assembly configured to support a substrate, the substrate support assembly comprising a movable substrate support configured to support the substrate,
   a level sensor,
   an alignment sensor, and
   a control unit configured to:
      - control the movable substrate support to displace the substrate relative to the level sensor according to a predefined path in order for the level sensor to determine a substrate height map;
      - control the movable substrate support to adjust the displacement of the substrate at an adjustment point along the predefined path in order for the alignment sensor to determine a position of an alignment mark which is arranged at or near the adjustment point along the predefined path.
2. The substrate support compartment according to clause 1, wherein the control unit is configured to:
   - control, while the substrate is displaced relative to the level sensor, the level sensor to determine the substrate height map; and
   - control, while the displacement of the substrate is adjusted, the alignment sensor to determine the position of the alignment mark.
3. The substrate support compartment according to any one of the preceding clauses, wherein the control unit is configured to:
   - control the level sensor to interrupt the determining of the substrate height map while the displacement of the substrate is adjusted.
4. The substrate support compartment according to any one of the preceding clauses, wherein the predefined path comprises alternating scanning sections and return sections, and wherein the control unit is configured to control the movable substrate support to accelerate when the movable substrate support approaches a scanning section and to control the movable substrate support to decelerate when the substrate support approaches or enters a return section.
5. The substrate support compartment according to clause 4, wherein the adjustment point along the predefined path is located along a scanning section of the predefined path.
6. The substrate support compartment according to any one of the preceding clauses, wherein the control unit is configured to control the movable substrate support to decelerate when the movable substrate support approaches the adjustment point along the predefined path.
7. The substrate support compartment according to any one of the preceding clauses, wherein the alignment sensor is configured to determine the position of the alignment mark by providing and scanning a patterned radiation beam relative to the alignment mark on the substrate.
8. The substrate support compartment according to any one of the preceding clauses, wherein the control unit is configured to control the movable substrate support to move to a detecting area in which the alignment mark is detectable by the alignment sensor in order for the alignment sensor to determine the position of the alignment mark.
9. The substrate support compartment according to clause 8, wherein the control unit is configured to control the movable substrate support to displace the substrate such that the alignment mark is displaced relative to the alignment sensor within the detecting area.
10. The substrate support compartment according to any one of the preceding clauses, wherein the control unit is configured to, after the alignment sensor has determined the position of the alignment mark, control the movable substrate support to resume the displacement of the substrate relative to the level sensor from the adjustment point along the predefined path onwards.
11. The substrate support compartment according to clause 10, wherein the control unit is configured to, after the alignment sensor has determined the position of the alignment mark and before controlling the movable substrate support to resume the displacement of the substrate relative to the level sensor from the adjustment point along the predefined path onwards, control the movable substrate support to move to a height measuring position in which the substrate height at the adjustment point along the predefined path is measurable by the level sensor.
12. The substrate support compartment according to any one of the preceding clauses, wherein the control unit is configured to control the movable substrate support to accelerate from the adjustment point along the predefined path onwards.
13. The substrate support compartment according to any one of the preceding clauses, wherein the alignment mark is arranged at a distance from the adjustment point along the predefined path, which distance is smaller than a threshold distance.
14. The substrate support compartment according to any one of the preceding clauses, wherein the alignment mark is arranged near an edge of the substrate, e.g., at a distance of 0.5cm or 1cm from the edge of the substrate.
15. The substrate support compartment according to any one of the preceding clauses, wherein the alignment sensor is configured to determine the position of the alignment mark in a support plane in which the substrate is configured to be supported on the substrate support, and wherein the level sensor is configured to measure the height of the substrate in a direction perpendicular to the support plane.
16. The substrate support compartment according to any one of the preceding clauses, wherein the control unit is configured to control the movable substrate support to adjust the displacement of the substrate at a plurality of adjustment points along the predefined path in order for the alignment sensor to determine the positions of a plurality of alignment marks which are each arranged at or near a respective adjustment point along the predefined path.
17. The substrate support compartment according to clause 16, wherein the positions of the plurality of alignment marks are determined as part of a course wafer alignment, COWA, procedure to determine location and orientation information of the substrate.
18. The substrate support compartment according to clause 17, wherein the positions of the plurality of alignment marks determined as part of the COWA procedure are used as input to a fine wafer alignment, FIWA procedure.
19. An exposure apparatus comprising a substrate support compartment according to any one of the preceding clauses.
20. A computer-implemented method of scanning a substrate supported by a movable substrate support of a substrate support compartment, the substrate support compartment further comprising an alignment sensor and a level sensor, the method comprising the following steps:
   - controlling the movable substrate support to displace the substrate relative to the level sensor according to a predefined path in order for the level sensor to determine a substrate height map;
   - controlling the movable substrate support to adjust the displacement of the substrate at an adjustment point along the predefined path in order for the alignment sensor to determine a position of an alignment mark which is arranged at or near the adjustment point along the predefined path.
21. A computer program comprising instructions to cause the control unit of the substrate support compartment according to any one of clauses 1-19 to execute the steps of the method according to clause 20.

## Claims

1. A substrate support compartment for an exposure apparatus comprising:
a substrate support assembly configured to support a substrate, the substrate support assembly comprising a movable substrate support configured to support the substrate,
a level sensor,
an alignment sensor, and
a control unit configured to:
• control the movable substrate support to displace the substrate relative to the level sensor according to a predefined path in order for the level sensor to determine a substrate height map;
• control the movable substrate support to adjust the displacement of the substrate at an adjustment point along the predefined path in order for the alignment sensor to determine a position of an alignment mark which is arranged at or near the adjustment point along the predefined path.

2. The substrate support compartment according to claim 1, wherein the control unit is configured to:
• control, while the substrate is displaced relative to the level sensor, the level sensor to determine the substrate height map; and
• control, while the displacement of the substrate is adjusted, the alignment sensor to determine the position of the alignment mark.

3. The substrate support compartment according to any one of the preceding claims,
wherein the control unit is configured to:
• control the level sensor to interrupt the determining of the substrate height map while the displacement of the substrate is adjusted.

4. The substrate support compartment according to any one of the preceding claims,
wherein the predefined path comprises alternating scanning sections and return sections, and wherein the control unit is configured to control the movable substrate support to accelerate when the movable substrate support approaches a scanning section and to control the movable substrate support to decelerate when the substrate support approaches or enters a return section.

5. The substrate support compartment according to claim 4, wherein the adjustment point along the predefined path is located along a scanning section of the predefined path.

6. The substrate support compartment according to any one of the preceding claims,
wherein the control unit is configured to control the movable substrate support to decelerate when the movable substrate support approaches the adjustment point along the predefined path.

7. The substrate support compartment according to any one of the preceding claims,
wherein the alignment sensor is configured to determine the position of the alignment mark by providing and scanning a patterned radiation beam relative to the alignment mark on the substrate.

8. The substrate support compartment according to any one of the preceding claims,
wherein the control unit is configured to control the movable substrate support to move to a detecting area in which the alignment mark is detectable by the alignment sensor in order for the alignment sensor to determine the position of the alignment mark.

9. The substrate support compartment according to claim 8, wherein the control unit is configured to control the movable substrate support to displace the substrate such that the alignment mark is displaced relative to the alignment sensor within the detecting area.

10. The substrate support compartment according to any one of the preceding claims,
wherein the control unit is configured to, after the alignment sensor has determined the position of the alignment mark, control the movable substrate support to resume the displacement of the substrate relative to the level sensor from the adjustment point along the predefined path onwards.

11. The substrate support compartment according to claim 10, wherein the control unit is configured to, after the alignment sensor has determined the position of the alignment mark and before controlling the movable substrate support to resume the displacement of the substrate relative to the level sensor from the adjustment point along the predefined path onwards, control the movable substrate support to move to a height measuring position in which the substrate height at the adjustment point along the predefined path is measurable by the level sensor.

12. The substrate support compartment according to any one of the preceding claims,
wherein the control unit is configured to control the movable substrate support to accelerate from the adjustment point along the predefined path onwards.

13. The substrate support compartment according to any one of the preceding claims,
wherein the alignment mark is arranged at a distance from the adjustment point along the predefined path, which distance is smaller than a threshold distance.

14. The substrate support compartment according to any one of the preceding claims, wherein the alignment mark is arranged near an edge of the substrate, e.g., at a distance of 0.5cm or 1cm from the edge of the substrate.

15. The substrate support compartment according to any one of the preceding claims, wherein the alignment sensor is configured to determine the position of the alignment mark in a support plane in which the substrate is configured to be supported on the substrate support, and wherein the level sensor is configured to measure the height of the substrate in a direction perpendicular to the support plane.

16. The substrate support compartment according to any one of the preceding claims, wherein the control unit is configured to control the movable substrate support to adjust the displacement of the substrate at a plurality of adjustment points along the predefined path in order for the alignment sensor to determine the positions of a plurality of alignment marks which are each arranged at or near a respective adjustment point along the predefined path.

17. The substrate support compartment according to claim 16, wherein the positions of the plurality of alignment marks are determined as part of a course wafer alignment, COWA, procedure to determine location and orientation information of the substrate.

18. The substrate support compartment according to claim 17, wherein the positions of the plurality of alignment marks determined as part of the COWA procedure are used as input to a fine wafer alignment, FIWA procedure.

19. An exposure apparatus comprising a substrate support compartment according to any one of the preceding claims.

20. A computer-implemented method of scanning a substrate supported by a movable substrate support of a substrate support compartment, the substrate support compartment further comprising an alignment sensor and a level sensor, the method comprising the following steps:
• controlling the movable substrate support to displace the substrate relative to the level sensor according to a predefined path in order for the level sensor to determine a substrate height map;
• controlling the movable substrate support to adjust the displacement of the substrate at an adjustment point along the predefined path in order for the alignment sensor to determine a position of an alignment mark which is arranged at or near the adjustment point along the predefined path.

21. A computer program comprising instructions to cause the control unit of the substrate support compartment according to any one of claims 1-19 to execute the steps of the method according to claim 20.
